(19) Europäisches Patentamt
European Patent Office
Office européen des brevets

(11) **EP 2 041 332 B1**

(12) **EUROPÄISCHE PATENTSCHRIFT**

(45) Veröffentlichungstag und Bekanntmachung des Hinweises auf die Patenterteilung:
**02.03.2011 Patentblatt 2011/09**

(21) Anmeldenummer: **07802376.9**

(22) Anmeldetag: **11.07.2007**

(51) Int Cl.:
***C23C 16/04*** *(2006.01)*

(86) Internationale Anmeldenummer:
**PCT/EP2007/057117**

(87) Internationale Veröffentlichungsnummer:
**WO 2008/006856 (17.01.2008 Gazette 2008/03)**

(54) **VERFAHREN UND VORRICHTUNG ZUR PLASMAGESTÜTZTEN CHEMISCHEN GASPHASENABSCHEIDUNG AN DER INNENWAND EINES HOHLKÖRPERS**

METHOD AND DEVICE FOR PLASMA-ASSISTED CHEMICAL VAPOUR DEPOSITION ON THE INNER WALL OF A HOLLOW BODY

PROCÉDÉ ET DISPOSITIF DE SÉPARATION CHIMIQUE EN PHASE GAZEUSE ASSISTÉE PAR PLASMA SUR LA PAROI INTÉRIEURE D'UN CORPS CREUX

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **12.07.2006 DE 102006032568**

(43) Veröffentlichungstag der Anmeldung:
**01.04.2009 Patentblatt 2009/14**

(73) Patentinhaber: **Stein, Ralf**
**44229 Dortmund (DE)**

(72) Erfinder: **NÖLL, Oliver**
**34613 Schwalmstadt (DE)**

(74) Vertreter: **Michalski, Stefan**
**Michalski Hüttermann & Partner**
**Patentanwälte**
**Neuer Zollhof 2**
**40221 Düsseldorf (DE)**

(56) Entgegenhaltungen:
DE-A- 4 242 894    DE-A1- 3 821 815
DE-A1- 4 318 084    US-A1- 2003 143 821
US-B1- 6 180 191

**Beschreibung**

Die Erfindung bezieht sich auf ein Verfahren zur plasmagestützten chemischen Gasphasenabscheidung zur Beschichtung bzw. Materialabtragung an der Innenwand eines Hohlkörpers.

Solche Verfahren sind unter den Gattungsbegriffen Plasmabeschichten (PECVD, "Plasma Enhanced Chemical Vapour Deposition") bzw. Ionenätzen und Plasmaätzen bekannt.

Hierbei wird ein Werkstück in eine Vakuumkammer eingebracht und dort fixiert. Die Kammer wird bis auf einen Restgasdruck im Hochvakuum- bzw. Ultrahochvakuum-Bereich evakuiert und ein inertes Arbeitsgas eingelassen. Durch Einspeisung eines HF-Feldes über eine in der Vakuumkammer angeordnete HF-Elektrode wird anschließend ein Niederdruck-Plasma gezündet. Hierbei wird ein ionisiertes Gas erzeugt, das zu einem nennenswerten Anteil sich schnell bewegende freie Ladungsträger wie Ionen oder Elektronen enthält.

Bei der PECVD werden neben dem Arbeitsgas weitere sogenannte Reaktionsgase in die Kammer eingespeist, die insbesondere kohlenstoffhaltig oder siliziumhaltig sein können. In dem Niederdruck-Plasma haben die Elektronen solch hohe Energien, dass chemische Reaktionen zwischen den Gasbestandteilen und Bestandteilen der Oberfläche des Werkstücks möglich sind, die im thermischen Gleichgewicht nicht möglich sind. Auf diese Weise bilden sich auf der Oberfläche des Werkstücks Schichten aus, die je nach Reaktionsgas z.B. aus Kohlenstoff oder Siliziumoxid bestehen können. Es lassen sich so zum Beispiel hochfeste, reibungsarme und biokompatible diamantähnliche Kohlenstoffbeschichtungen (DLC, "Diamond-like Carbon") herstellen, die z.B. in Implantaten, Zahnrädern und dergleichen zum Einsatz kommen.

Beim Ionenätzen und Plasmaätzen geht es hingegen darum, Material von der Oberfläche des Werkstücks abzutragen, um letzteres z.B. zu reinigen. Hierfür müssen die Ionen des erzeugten Niederdruckplasmas eine gewisse Mindestenergie besitzen. Die Beschleunigung von Argonionen im Hochvakuum in Richtung des zu bearbeitenden Substrats, führt dazu, dass beim Auftreffen eine Impulsübertragung von den hochenergetischen Ionen auf das Substrat stattfindet und dessen Oberfläche zerstäubt und gleichmäßig abgetragen wird. Beim Plasmaätzen erfolgt das Ätzen zudem durch eine chemische Reaktion. Hierbei wird statt reinem Argon dem Plasma ein reaktives Gas wie z.B. Sauerstoff zugeführt.

Sowohl die PECVD als auch das Ionenätzen bzw. Plasmaätzen haben sich in der Oberflächenbehandlung von Werkstücken außerordentlich bewährt. Allerdings eignen sich beide Verfahren zumindest bei Erzeugung eines Plasmas durch Hochfrequenzanregung nicht zur Beschichtung bzw. zum Ätzen der inneren Oberflächen von Hohlkörpern, wie z.B. Kannen, Flaschen, Rohren, Kanülen, Bohrungen und dergleichen.

Dies liegt daran, dass leitende Hohlkörper im elektrischen Feld einen Faraday'schen Käfig bilden. Die erzeugten Ionen orientieren sich an den Feldlinien dieses elektrischen Feldes. Da diese um die Außenwand des Hohlköpers entlang verlaufen, nicht aber durch sein Innenvolumen, ist eine Innenbeschichtung ohne weiteres physikalisch nicht möglich. Zum Umgehen dieses Effektes muss das Plasma in das Innenvolumen des Hohlköpers gebracht werden. Dabei müsste in das Innenvolumen eine negative Fläche eingebracht werden, die die Rolle der Kammerinnenwand als Negativfläche ersetzt. Die Größe der negativen Fläche muss dabei grundsätzlich mindestens doppelt so groß sein wie die zu beschichtende Oberfläche, um eine für den Schichtaufbau ausreichende Abscheidung zu gewährleisten. Demnach ist die Einhaltung dieses Grundsatzes innerhalb eines Hohlkörpers praktisch nicht möglich.

Bei einem zylindrischen Hohlkörper beträgt beispielsweise die innere Oberfläche der Zylinderwand A = 2 nrh. Eine flächige Elektrode könnte, senkrecht in dem Hohlkörper aufgestellt, jedoch maximal eine Oberfläche von 2rh aufweisen, wäre also um den Faktor 3,14 kleiner als die zu beschichtende Oberfläche, und nicht; wie technisch erforderlich, doppelt so groß.

Ähnliche Verhältnisse gelten für andere Hohlkörper wie z.B. Kegel und Kegelstümpfe oder komplex geformte Hohlkörper.

Die DE 197 26 443 beschreibt ein Verfahren zur Oberflächenvergütung innerer Oberflächen von Hohlkörpern, bei dem das Plasma durch eine Hohlkathodenglimmentladung gezündet wird. Nachteilig ist hier, dass nur relativ kurze Hohlkörper, bei denen die Tiefe den Öffnungsdurchmesser nicht übersteigt, von innen beschichtet werden können. In einer Variante, die die Innenbeschichtung längerer Hohlkörper ermöglicht; ist vorgesehen, dass die Hohlkathode in den Hohlkörper eingeschoben wird und an der Innenseite entlang läuft. So können zwar längere Hohlkörper innenbeschichtet werden, diese müssen jedoch einen geradlinigen Wandverlauf aufweisen.

US6180191 B1 offenbart eine Vorrichtung und ein Verfahren zum plasmagestützten Beschichten einer Innenwand eines Hohlkörpers.

Die EP 1 548 149 beschreibt ein Verfahren zur Ausbildung einer dünnen Oxid-Beschichtung auf der Innenseite eines Hohlkörpers. Hierbei wird ein auf der Innenseite zu beschichtender Hohlkörper in eine zylindrische Kammer eingebracht, die als HF-Elektrode fungiert. Ein Gasrohr, das gleichzeitig als Masse-Elektrode fungiert, wird in den Innenraum des Hohlkörpers eingebracht.

Der Nachteil dieses Verfahrens liegt in der Ausbildung der Schichteigenschaften Das Gasrohr fungiert in der in der EP 1 548 149 beschriebenen Vorrichtung als Masse-Elektrode. Aus diesem Grunde sind die Schichteigenschaften (Härte, Dicke, Gitterstruktur der Abscheidung, Reinheit der Schicht, Dotierung mit funktionellen Elementen, wasserabweisend oder - aufnehmend) nicht wie gewollt einzustellen.

Die Einstellung und Kontrolle dieser Eigenschaften ist bei einer eingebrachten Masse-Elektrode, welche in Bezug auf ihre Fläche um den Faktor 1 kleiner ist als die zu beschichtende Fläche, nicht möglich.

Aus der DE3821815 ist eine Vorrichtung zur Beschichtung einer Innenwand eines Hohlkörpers mit einer diamantartigen, harten Kohlenstoffbeschichtung mit Hilfe eines plasmagestützten CVD-Verfahrens bekannt. Dabei wird ein wenigstens ein Kohlenwasserstoffgas enthaltendes Prozessgas durch den Innenraum des unbeheizten Hohlkörpers geleitet, in dem ein Plasma das Prozessgas anregt, wobei es dissoziiert und ionisiert wird und die so entstandenen Ionen zur Ausbildung der Beschichtung auf die zu beschichtende Innenwand beschleunigt werde. Die Vorrichtung weist einen HF-Generator auf, der an den Hohlkörper angeschlossen ist, mit einer Erdung zur Ausbildung des Plasmas zwischen dem Hohlkörper und der Erdung und mit einer in den Innenraum des Hohlkörpers mündenden Zufuhrleitung für die gesteuerte Einleitung des Prozessgases in den Innenraum des Hohlkörpers. Die Erdung ist an ein Vakuumgehäuse angeschlossen ist, in das der Innenraum des Hohlkörpers einmündet und das den Hohlkörper von der Einmündung beabstandet umgibt.

Diese Vorrichtung hat sich in der Praxis aus verschiedenen Gründen als nicht geeignet erwiesen. So wird bei dem mit dieser Vorrichtung durchgeführten Verfahren neben der Innenwand des besagten Hohlkörpers auch dessen Außenwand beschichtet. Weiterhin eignet sich diese Vorrichtung lediglich für die Beschichtung von Hohlkörpern mit geradlinigem Innenverlauf (sogenannte "Sacklöcher"), also z.B. nicht für kannenartige Gefäße mit einem verengten Hals.

Hinzu kommt, dass in dieser Vorrichtung der Hohlkörper selbst als Elektrode fungiert, da er leitend mit der Hochfrequenzelektrode in Verbindung steht. Dies ist bei dieser Vorrichtung erforderlich, da ansonsten die Feldstärke des erzeugten elektromagnetischen Wechselfeldes nicht ausreichen würde, um eine Innenbeschichtung zu gewährleisten. Die Durchschlagtiefe eines lediglich durch die Hochfrequenzelektrode im Basisbereich der Vakuumkammer erzeugten elektromagnetischen Wechselfeldes (d.h. die maximale Dicke eines ggf. metallischen Materials, durch welche das Wechselfeld in ausreichender Stärke dringt, um noch eine Beschichtungsreaktion auszulösen) liegt bei dieser Vorrichtung im Bereich von 2 cm. Hohlkörper mit einer größeren Wandstärke sind also bei dieser Vorrichtung darauf angewiesen, dass sie selbst als Elektrode fungieren; sie müssen daher zwangsläufig aus Metall bestehen.

Weiterhin hat sich herausgestellt, dass die Geometrien der zu beschichtenden Hohlkörper sehr limitiert sind. So wird zwar beschrieben, dass sich neben Werkstücken mit einem Verhältnis von Rohrdurchmesser zu Rohrlänge im Bereich zwischen 20 mm zu 60 mm und 2 mm zu 20 mm auch Rohrdurchmesser grösser als 20 mm bzw. kleiner als 2 mm mit dieser Vorrichtung beschichten lassen, dies hat sich in der Praxis jedoch als problematisch herausgestellt.

Das genannte Verfahren eignet sich daher nicht für eine Vielzahl von Anwendungsfällen, bei denen Hohlkörper mit größerem Innendurchmesser beschichtet werden sollen.

Aufgabe der vorliegenden Erfindung ist es, eine Vorrichtung und ein Verfahren zur plasmagestützten chemischen Gasphasenabscheidung zur Beschichtung bzw. Materialabtragung an der Innenwand eines Hohlkörpers zur Verfügung zu stellen, das die genannten Nachteile nicht aufweist.

Diese Aufgabe wird mit einem Verfahren bzw. einer Vorrichtung aufweisend die Merkmale der neu vorgelegten Ansprüche 1 und 11 gelöst. Die Unteransprüche geben bevorzugte Ausführungsformen an.

Dabei ist zu beachten, dass Wertebereiche, die durch Zahlenwerte begrenzt sind, immer einschließlich der betreffenden Zahlenwerte zu verstehen sind.

Demnach ist ein Verfahren zur plasmagestützten chemischen Gasphasenabscheidung zur Beschichtung bzw. Materialabtragung an der Innenwand eines Hohlkörpers, insbesondere aus einem nichtmetallischen Material, mit einer Querschnittsfläche, einer Längserstreckung und mindestens einer Öffnung vorgesehen. Das Verfahren weist die folgenden Schritte auf:

1. Einbringen des auf seiner Innenseite zu beschichtenden Hohlkörpers in eine Vakuumkammer mit einer geerdeten Innenseite, wobei im Inneren der Vakuumkammer eine großflächige Hochfrequenz-Elektrode angeordnet ist,

2. Positionieren des Hohlkörpers in der Mitte der Vakuumkammer, wobei ein allseitiger Mindestabstand zwischen der Außenwand des Hohlkörpers und der Innenwand der Vakuumkammer von 15 cm einzuhalten ist,

3. Einbringen einer Gaslanze bestehend aus einem Rohr mit einem Innendurchmesser von 0.001 - 10 mm, einem maximalen Außendurchmesser von 12 mm sowie einer endständigen Düse mit einem terminalen Öffnungsdurchmesser von 0.002 - 6 mm durch die Öffnung in den Hohlkörper, wobei die Gaslanze über eine nicht elektrisch leitende Leitung mit einer Gaszufuhreinrichtung verbunden ist und insbesondere nicht geerdet ist oder in elektrisch leitendem Kontakt mit der Hochfrequenzelektrode steht,

4. Positionieren der Gaslanze in dem Hohlkörper dergestalt, dass die Gaslanze bezogen auf den Querschnitt des Hohlkörpers mittig positioniert ist und die Düse der Gaslanze bezogen auf die Längserstreckung des Höhlgefäßes im Bereich des Übergangs vom zweiten Längsdrittel zum dritten Längsdrittel, gemessen von der Öffnung des Hohlkörpers, angeordnet ist,

5. Verschließen der Vakuumkammer und Evakuieren derselben auf einen Restdruck von 0,001 - 5 Pascal,

6. Einleiten eines inerten Arbeitsgases sowie eines oder mehrerer Reaktionsgase über die Gaszufuhreinrichtung und die Gaslanze in den Hohlkörper, sowie

7. Zünden eines Hohlraumplasmas unter Ausbildung einer an der Spitze der Gaslanze angeordneten Plasmawolke durch Anlegen eines elektrischen Hochfrequenzfeldes an der HF-Elektrode.

Es ist dabei relevant, dass der zu beschichtende Hohlkörper nicht geerdet ist. Bevorzugt ist dabei vorgesehen, dass die Vakuumkammer auf einen Restdruck von 0,01 - 2 Pascal evakuiert wird. Besonders bevorzugt wird die Vakuumkammer auf einen Restdruck von 0,1 - 1 Pascal evakuiert.

Wichtig bei diesem Verfahren ist, dass die Gaslanze nicht an Masse oder an Erde anliegt, sondern elektrisch isoliert ist. Hierzu ist bevorzugt vorgesehen, dass sie mit Hilfe eines PTFE-Ringes (Polytetrafluorethylen) isoliert ist und die Gaszuleitung innerhalb des Kammerinnenraumes aus PTFE gefertigt ist.

Als zu beschichtende Hohlkörper kommen grundsätzlich alle möglichen Hohlkörper in Frage, also sowohl einseitig geschlossene Hohlkörper (wie z.B. Gefäße, Kannen etc) als auch rohrförmige Hohlkörper ohne Boden, wie z.B. Kanülen, Körper mit einer Durchgangsbohrung oder Rohre. Letztere Hohlkörper müssen vor der Beschichtung auf einer Seite mit einem Deckel oder Stopfen verschlossen werden.

In beiden Fällen muss dafür Sorge getragen werden, dass die Gaslanze in dem Hohlkörper dergestalt angeordnet ist, dass die Gaslanze bezogen auf den Querschnitt des Hohlkörpers mittig positioniert ist und die Düse der Gaslanze bezogen auf die Längserstreckung des Hohlgefäßes im Bereich des Übergangs vom zweiten Längsdrittel zum dritten Längsdrittel, gemessen von der Öffnung des Hohlkörpers, angeordnet ist. Dies bedeutet, dass die Gaslanze bis relativ kurz vor den Boden des Gefäßes (bzw. vor die mit einem Deckel oder Stopfen verschlosene zweite Öffnung des Hohlkörpers) vorgeschoben werden muss. Hierbei muss ein Mindestabstand von 10 cm eingehalten werden. Bei Substratobjekten, die eine Tiefe von 10 cm oder weniger aufweisen, wird die Spitze der Gaslanze direkt oberhalb der Öffnung des Hohlkörpers positioniert.

Grundsätzlich gewährleisten Niederdruckplasmen wie in der vorliegenden Erfindung eine größere mittlere freie Weglänge λ der Gasmoleküle und verzögern daher die Ausbildung eines Plasmas. Durch die erfindungsgemäße Anordnung der Gaslanze wird hingegen bewirkt, dass die aus der Gaslanze austretenden Gasmoleküle durch ihre Beschleunigung gegen den Gefäßboden bzw. den erwähnten Deckel oder Stopfen prallen. Hierdurch wird der Aufspaltungsvorgang des Gases und die Ausbildung eines Plasmas begünstigt. Aus diesem Grunde ist eine vergleichsweise geringere Stärke des elektromagnetischen Wechselfeldes ausreichend, d.h. es ist nicht erforderlich, dass der zu beschichtende Hohlkörper selbst als Elektrode fungiert.

Bevorzugt beträgt der Mindestabstand zwischen der Außenwand des Hohlkörpers und der Innenwand der Vakuumkammer 15 cm. Der maximale Abstand ist hingegen durch die Dimensionierung der verwendeten Vakuumkammer gegeben.

Die Gaslanze weist bevorzugt einem Innendurchmesser von 0,005 - 6 mm und besonders bevorzugt einen Innendurchmesser von 0,01 - 6 mm bzw. 0,1 - 6 mm und einem maximalen Außendurchmesser von 10 bzw. 8 mm auf. Die endständige Düse weist bevorzugt einen terminalen Öffnungsdurchmesser von 0,01 - 3 bzw. von 0,1 bis 2 mm auf.

Durch die Anordnung und Dimensionierung der Gaslanze wird gewährleistet, dass sich das Plasma erst an der Spitze der Gaslanze ausbildet, d.h. erst im Inneren des zu beschichtenden Hohlkörpers. Da die Gasmoleküle im Augenblick der plasmabedingten Aufspaltung am stärksten beschleunigt werden, kommt diese Beschleunigung im vollen Umfang der Behandlung der Innenoberfläche des Hohlkörpers zugute. Daher ist auch eine Elektrode im Inneren des Hohlkörpers verzichtbar.

Es gelingt auf diese Weise die Zündung und Erhaltung eines Plasmas lediglich im Inneren des Hohlkörpers. Diese Art des Plasmas wird im Folgenden auch als "Hohlraumplasma" bezeichnet. Hierdurch wird gewährleistet, dass besagter Hohlkörper lediglich auf der Innenseite und nicht auf seiner Außenseite beschichtet wird.

In dem Augenblick, in welchem das Gasgemisch die Lanzendüse verlässt, findet die plasmabedingte molekulare Aufspaltung statt. Diese erfolgt unter Bildung von sehr kurzwelligem Licht.

Die bei der Aufspaltung freiwerdende Abspaltenergie beschleunigt die nun im eigentlichen Sinne "Plasmamaterie" auf ca. 250.000 km/h. Aufgrund dieser Beschleunigung trifft der Kohlenstoff auf die zu beschichtende innere Oberfläche auf und schlägt sich als Hartstoffschicht nieder. Die Abscheideart variiert in Abhängigkeit des eingesetzten Gases, dessen Reinheit und Zusammensetzung.

Das Aufspaltungsverhältnis liegt z.B. bei $H_2C_2$ bei 1:12. Das bedeutet, dass die H-Atome 12 mal leichter sind als die C-Atome. Die Beschleunigung der Aufspaltung zuzüglich der Beschleunigung der einzelnen Atome und das Auftreffens auf das Substrat liegt also im Verhältnis 1:12.

Es treffen also im gleichen Zeitraum auf identischer Fläche zwölfmal mehr C-Atome bei gleicher Geschwindigkeit wie H-Atome auf. Da die H-Atome in einer Hartstoffschicht unerwünscht sind, muß die eingefüllte Menge Reaktionsgas auf die zu beschichtende Innenfläche berechnet werden.

Für die Berechnung der einzufüllenden Menge Reaktionsgas kann folgende, durch den Erfinder empirisch ermittelte Beziehung herangezogen werden:

$$V = A / 12 * E$$

Hierbei ist A die zu beschichtende Oberfläche [cm$^2$], E die zugeführte Aufspaltungsenergie ist, und V das Minutenvolumen des Reaktionsgases [cm$^3$/min].

Aufgrund der Massenträgheit und der freiwerdenden Aufspaltungsenergie benötigt der Kohlenstoff also weniger Fläche pro Beschleunigungsfreiraum, um auf die geforderten 250.000 km/h zu kommen.

Bringt man nun das $H_2C_2$ mit einer Gaslanze in einen dreidimensionalen Hohlkörper, so muss gewährleistet werden, dass die C-Atome bei maximaler Beschleunigung direkt auf das Substrat treffen und nicht durch gleichwertig beschleunigte H-Atome abgelenkt, abgebremst oder sogar gestoppt werden.

Dieses wird gewährleistet, indem die Düse der Gaslanze bezogen auf die Längserstreckung des Höhlgefäßes im Bereich des Übergangs vom zweiten Längsdrittel zum dritten Längsdrittel, gemessen von der Öffnung des Hohlkörpers, angeordnet wird. Dadurch werden die Atome bis zu ihrem Maximum beschleunigt und treffen direkt am Ende dieser Phase auf das Substrat auf, ohne von anderen Atomen behindert zu werden.

Untersuchungen des Erfinders haben überdies ergeben, dass, um die erwähnte Abscheidung auf der inneren Oberfläche eines Hohlkörpers zu gewährleisten, die Aufspaltenergie ($E_A$) in Watt mindestens um den Faktor 65,5 höher sein muss als der Öffnungsdurchmesser ($D_ö$) des Hohlkörpers in cm.

Dies bedeutet also, dass bei einem Öffnungsdurchmesser ($D_ö$) des Hohlkörpers von 15 cm die Aufspaltenergie ($E_A$) aufgrund der Beziehung

$$E_A = D_ö * 65,5$$

mindestens 15* 65,5 = 982 Watt betragen muss.

Durch Einbringung dieser Mindest-Aufspaltungsenergie, die sich am HF-Generator entsprechend einstellen lässt, werden die Atome des in das Plasma übergegangenen Reaktionsgases derart beschleunigt, dass deren Schwingungsamplitude größer ist als der Öffnungsdurchmesser des Hohlkörpers. Es wird so gewährleistet, dass nur noch querbeschleunigte Atome den Hohlkörper verlassen können.

Auf diese Weise lässt sich, entgegen dem eingangs Gesagten, mit dem erfindungsgemäßen Verfahren auch die innere Oberfläche eines Hohlkörpers beschichten.

Durch die Dimensionierung der Düse der Gaslanze wird dabei verhindert, dass das Plasma in die Gaslanze zurückschlägt, wie es bei größer dimensionierten Düsen zu befürchten wäre.

Wichtig ist auch, dass sich der Durchmesser der Gaslanze in Richtung der Düse nicht erweitert. Hierdurch würde aufgrund des Bernoulli-Effekts der Druck des einströmenden Gases in Stromrichtung im Bereich der Querschnittserweiterung abnehmen, was ein Rückschlagen des Plasmas in die Gaslanze und damit eine Zerstörung der Gaslanze begünstigen würde. Auf diese Weise würde die Ausbildung der Plasmawolke an der Spitze der Gaslanze unterbunden.

Im erfindungsgemäßen Verfahren ist vorgesehen, dass die Hochfrequenz-Elektrode im Inneren der Vakuumkammer mindestens zwei Zuleitungen, über die Hochfrequenz-Spannungen in die Hochfrequenz-Elektrode einspeisbar sind, aufweist.

Auf diese Weise läßt sich in der Kammer ein Wechselfeld mit sehr hohen Feldstärken erzeugen, wie es zur Ausbildung des Hohlraumplasmas erforderlich ist. Ein auf diese Weise erzeugtes Wechselfeld weist eine ausreichend hohe Durchschlagtiefe auf, so dass auch Hohlkörper mit großen Wandstärken durchdrungen und auf der Innenseite beschichtet werden können. Der Hohlkörper selbst muß also nicht als Elektrode fungieren und kann daher auch aus einem nichtmetallischen Material bestehen. Es ist daher irrelevant, ob der Hohlkörper in elektrisch leitendem Kontakt mit der Hochfrequenzelektrode steht oder ob er vollkommen elektrisch isoliert ist.

Dieses Merkmal ist insbesondere mit der Eigenschaft von Vorteil, dass bei dem erfindungsgemäßen Verfahren die Temperaturen im Inneren der Beschichtungskammer in der Regel 200 °C nicht übersteigen. Aufgrund dieser geringen Temperaturen lassen sich also auch Kunststoffhohlkörper mit einer höchst widerstandsfähigen Innenbeschichtung versehen. Dies ist insbesondere deswegen vorteilhaft, weil sich aufgrund der nicht erforderlichen elektrisch leitenden Verbindung zwischen dem Hohlkörper und der Hochfrequenz-Elektrode mit dem erfindungsgemäßen Verfahren gerade auch nichtmetallische Hohlkörper beschichten lassen.

Bevorzugt sind dabei drei oder mehr Zuleitungen vorgesehen, da sich auf diese Weise ein noch homogeneres Wechselfeld einstellen lässt.

Dabei ist bevorzugt vorgesehen, dass die einzelnen Zuleitungen zu der Hochfrequenz-Elektrode separat eingeregelt werden, dergestalt, dass in der gesamten Kammer, ein homogenes Wechselfeld mit gleichmäßig hohen Feldstärken erzeugbar ist. Dieses Merkmal kommt der Beschichtungsgüte sehr zugute.

Dies kann z.B. über eine sogenannte Matchbox erfolgen, die zwischen einen Hochfrequenzgenerator und die Hochfrequenz-Elektrode geschaltet ist. Diese weist z.B. Trimmpotentiometer für die einzelnen Zuleitungen zu der Hochfrequenz-Elektrode auf, die separat eingeregelt werden. Dabei wird an allen Reglern die gleiche Biasspannung eingestellt, was auf identische Feldstärken und damit ein homogenes Wechselfeld schließen läßt.

In einer weiteren bevorzugten Ausgestaltung des erfindungsgemäßen Verfahrens ist vorgesehen, dass der besagte Hohlkörper lediglich eine Öffnung aufweist, deren engster Durchmesser schmaler ist als der engste Durchmesser des Innenraums des Hohlkörpers. Bei einem solchen Hohlkörper kann es sich z.B. um eine Bulkkanne, eine Flasche oder ähnliches handeln. Hohlkörper mit solchen Geometrien lassen sich insbesondere mit dem aus der DE3821815 bekannten Verfahren nicht beschichten.

Weiterhin ist bevorzugt vorgesehen, dass der besagte zu beschichtende Hohlkörper ein Innenvolumen im Bereich zwischen wenigen cm³ und 1.000.000 cm³ aufweist. Aus technischen Gründen ist der Größe des zu beschichtenden Hohlkörpers nur deswegen eine Grenze gesetzt, weil die Größe der derzeit erhältlichen Vakuum-Kammern limitiert ist.

So weist z.B. eine Bulkkanne ein Innenvolumen im Bereich von 10.000 - 100.000 cm³ auf. Ein Motorblock mit vier Zylindern weist z.B. vier Innenvolumina im Bereich zwischen 250 und 700 cm³ auf. Eine Gasflasche weist z.B. ein Innenvolumen im bereich von 20.000 - 100.000 cm³ auf.

Auch hier gilt, dass Hohlkörper mit solchen Volumina insbesondere mit dem aus der DE3821815 bekannten Verfahren nicht mit ausreichender Qualität beschichtet werden können.

Bevorzugt ist vorgesehen, dass es sich bei dem Arbeitsgas um ein Gas ausgewählt aus der Gruppe enthaltend Argon, Helium, Wasserstoff, Sauerstoff oder ein anderes Edelgas handelt.

Weiterhin ist besonders bevorzugt vorgesehen, dass es sich bei dem Reaktionsgas um ein Gas ausgewählt aus der Gruppe enthaltend Sauerstoff handelt.

Ein solches Verfahren zur plasmagestützten chemischen Gasphasenabscheidung zur Materialabtragung wird auch als Plasmaätzen bezeichnet. Als Reaktionsgas für dieses Verfahren ist Sauerstoff besonders geeignet, da die im Plasma erzeugten Sauerstoffionen besonders schwer sind und daher im beschleunigten Zustand besonders effektiv eine Oberflächenabtragung herbeiführen.

Untersuchungen der Anmelder haben ergeben, dass sich mit diesem Verfahren z.B. die innere Oberfläche einer benutzten Bulkkanne, wie sie z.B. für die Herstellung von Impfstoffen verwendet wird, und die nach Benutzung durch eingetrocknete und/oder chemisch Blutbestandteile aufs äußerste verschmutzt ist, aufs gründlichste reinigen lässt.

Gemäß geltender Vorschriften muss z.B. ein Edelstahl für die medizinische Verwendung absolut rückstandsfrei von vorherigen mit demselben in Kontakt stehenden Stoffen sein. Dies wurde bislang z.B. bei Bulkkannen durch einen sehr aufwändigen Reinigungsprozess mit Säuren und Laugen erreicht.

Mittels des erfindungsgemäßen Verfahrens, bei dem nach Zuführung von Sauerstoff unter hoher Energiezufuhr ein Plasma gezündet wird. gelingt es, die Oberfläche des Substrates absolut rückstandsfrei zu reinigen ("ätzen"). Dies ist insbesondere auf das hohe Atomgewicht der Sauerstoffatome zurückzuführen, die bei ausreichender Beschleunigung Verunreinigungen sicher abtragen.

In einer weiteren bevorzugten Ausgestaltung des erfindungsgemäßen Verfahrens ist vorgesehen, dass es sich bei dem Reaktionsgas um ein Gas ausgewählt aus der Gruppe enthaltend Kohlenwasserstoffgase wie Methan, Ethan, Ethen, Ethin, Propan oder Silangase wie Tetramethylsilan oder Hexamethyldisiloxan handelt.

Erstere Reaktionsgase sind geeignet zur Ausbildung einer DLC-Schicht, letztere z.B. geeignet zur Ausbildung einer $SiO_2$-Schicht.

Unter dem Begriff DLC ("Diamond-Like Carbons') werden Schichten aus molekularem Kohlenstoff verstanden, die ein Netz bzw. Gitter aus $sp^2$-und $sp^3$-hybridisierten Kohlenstoffatomen aufweisen. Das Verhältnis beider Varianten zueinander richtet sich nach den Beschichtungsbedingungen. Überwiegen erstere, weist die Beschichtung graphitähnliche Eigenschaften auf (geringer Reibungskoeffizient), überwiegen letztere, nimmt die Härte und die Transparenz der Beschichtung zu. Mischbeschichtungen enthaltend beide Varianten vereinigen häufig beide Vorteile.

Untersuchungen der Anmelder haben ergeben, dass sich mit diesem Verfahren die inneren Oberflächen von Bulkkannen und anderen Hohlkörpern effektiv mit einer DLC-Schicht beschichten lassen.

Bevorzugt wird bei dem erfindungsgemäßen Verfahren das Plasma durch Anlegen eines Gleichspannungs-Hochfrequenzfeldes mit den folgenden Parametern gezündet:

    1. Frequenz: 10 kHz - 100 GHz
    2. Elektrische Leistung: 500 - 5000 W
    3. Gaszufuhr: 0-90 scm³.

Die Frequenz liegt bevorzugt im Bereich von 10-15 MHz. Besondere bevorzugt beträgt die Frequenz 13,56 MHz (RF, Radiofrequenz).

Die einzubringende elektrische Leistung errechnet sich nach folgender Formel: Leistung (Watt) = zu beschichtende Fläche (m²) x 1750. Der letztgenannte Faktor kann dabei zwischen 1500 und 2200 liegen und wird in der Praxis empirisch ermittelt. Ein Hohlkörper mit einer zu beschichtenden inneren Oberfläche von 0,85 m² müßte demnach mit einer Energie von etwa 1500 Watt beschichtet werden.

Überraschenderweise liegt die sich unter diesen Umständen einstellende Biasspannung im Bereich von 0V, und zwar an allen Zuleitungen. Überdies ist dieser Wert unabhängig davon, ob der zu beschichtende Hohlkörper in elektrisch leitendem Kontakt mit der Hochfrequenz-Elektrode steht oder nicht.

Die Gaszufuhr wird gasspezifisch geregelt und je nach Objekt und gewünschten Schichteigenschaften in einem Bereich von 0-90 sccm eingeregelt. Bevorzugt ist dabei vorgesehen, dass die einzubringende Menge des Reaktionsgases für die Beschichtung 0,1 - 10 sccm Reaktionsgas pro 10 cm$^2$ zu beschichtende innere Oberfläche beträgt.

Die Einheit sccm bezeichnet Standard-Kubikzentimeter, d.h. das Volumen des einzuleitenden Gases in Kubikzentimeter pro Minute (Minutenvolumen). Für die Einregelung wird ein Ventil mit einem Mass Flow Controller verwendet. Bei gegebenem Druck der Gaszuleitung entscheidet also der Öffnungszustand des Ventils über das einströmende Minutenvolumen.

Bei Kohlenwasserstoffgasen gilt, dass die Schicht umso härter wird, je mehr Gas eingesetzt wird, da der Anteil an zur Verfügung stehenden Kohlenstoffatomen steigt.

Bei Silangasen gilt hingegen, dass das Verhältnis des Silangases zum Sauerstoff die Härte der Schicht bestimmt. Für harte Beschichtungen liegt das Verhältnis z.B. bei 100 sccm HMDSO (Hexamethyldisiloxan) zu 400 sccm Sauerstoff. Eine Reduktion des Sauerstoffanteils führt hingegen zu weicheren Schichten.

Besonders bevorzugt beträgt die einzubringende Menge des Reaktionsgases 0,5 - 5 sccm Reaktionsgas pro 10 cm$^2$ zu beschichtende innere Oberfläche.

Weiterhin ist bevorzugt vorgesehen, dass das Reaktionsgas mit einem oder mehreren Gasen enthaltend Si, N, F, B, O, Ag, Cu, V oder Ti dotiert ist. Diese Dotierungsmittel können dazu beitragen, die Eigenschaften der aufgebrachten Beschichtung gezielt zu beeinflussen. So führt z.B. die Dotierung des Reaktionsgases mit einem Gas enthaltend Si (z.B. Hexamthyldisiloxan) zu einer Reduzierung der Reibung auch unter feuchten Bedingungen sowie zu einer höheren thermischen Stabilität. Eine Dotierung mit N, F, B, oder O beeinflusst die Oberflächenspannung, die Benetzbarkeit und die Härte der Beschichtung. Eine Dotierung mit Metallen trägt dazu bei, die Leitfähigkeit der Beschichtung zu beeinflussen, während eine Dotierung mit Ag, Cu, V oder Ti das biologische Verhalten der Beschichtung beeinflusst, insbesondere die Biokompatibilität, was z.B. für Implantate immens wichtig ist.

Mit dem erfindungsgemäßen Verfahren werden Schichtwachstumsraten von bis zu 4 μm/h sowie Schichtdicken von bis zu 7 μm erzielt.

Erfindungsgemäß ist weiterhin ein Hohlkörper mit einer inneren Oberfläche vorgesehen, der dadurch gekennzeichnet ist, dass letztere mit einem Verfahren gemäß einem der vorherigen Ansprüche behandelt wurde, dergestalt dass an der inneren Oberfläche eine Materialabtragung vorgenommen wurde und/oder diese mit einer Beschichtung versehen wurde. Bei der Beschichtung kann es sich, wie oben erwähnt, z.B. um eine DLC- , eine TiOx oder eine SiO$_2$-Bechichtung handeln.

Besonderes bevorzugt handelt es sich bei diesem Hohlkörper um einen Hohlkörper ausgewählt aus der Gruppe enthaltend Gefäße, Flaschen, Kannen, Kanülen, Hohlnadeln, Spritzen, Innenwände von Zylinder- oder Kolbenbohrungen in Verbrennungsmotoren, Innenseiten von Lagern, insbesondere Kugel- oder Wälzlager.

Die genannten Hohlkörper können insbesondere aus nichtmetallischen Materialien bestehen, da der Hohlkörper - anders als in der DE 3821815 beschrieben - nicht als Elektrode fungiert. Dies eröffnet neue Möglichkeiten im Leichtgewichtsbau. So ist es z.B. möglich ein hochbelastetes metallisches Werkstück - so z.B. einen Motorblock eines Verbrennungsmotors - aus einem Kunststoff zu fertigen und die Innenwände der Zylinderbohrungen erfindungsgemäß mit einer hochbelastbaren Oberfläche zu beschichten.

Mit dem erfindungsgemäßen Verfahren lassen sich u. a. die folgenden Vorteile erzielen:

a) verbesserte Reinigung dreidimensionaler Hohlkörper, insbesondere Bulkkannen, bei gleichzeitig vermindertem Aufwand;
b) verbesserter Korrosionsschutz der beschichteten Oberflächen;
c) kein Hineindiffundieren eines in dem Hohlkörper befindlichen Substrates in die innere Oberflächenschicht des Hohlkörpers;
d) Reduktion des Reibungskoeffizienten der inneren Oberfläche; und
e) verbesserte Wärmeableitung.

Erfindungsgemäß ist weiterhin eine Vorrichtung zur Durchführung eines Verfahrens gemäß einem der vorherigen Ansprüche vorgesehen.

Die vorliegende Erfindung wird durch die im Folgenden gezeigten und diskutierten Figuren genauer erläutert. Dabei ist zu beachten, dass die Figuren nur beschreibenden Charakter haben und nicht dazu gedacht sind, die Erfindung in irgendeiner Form einzuschränken.

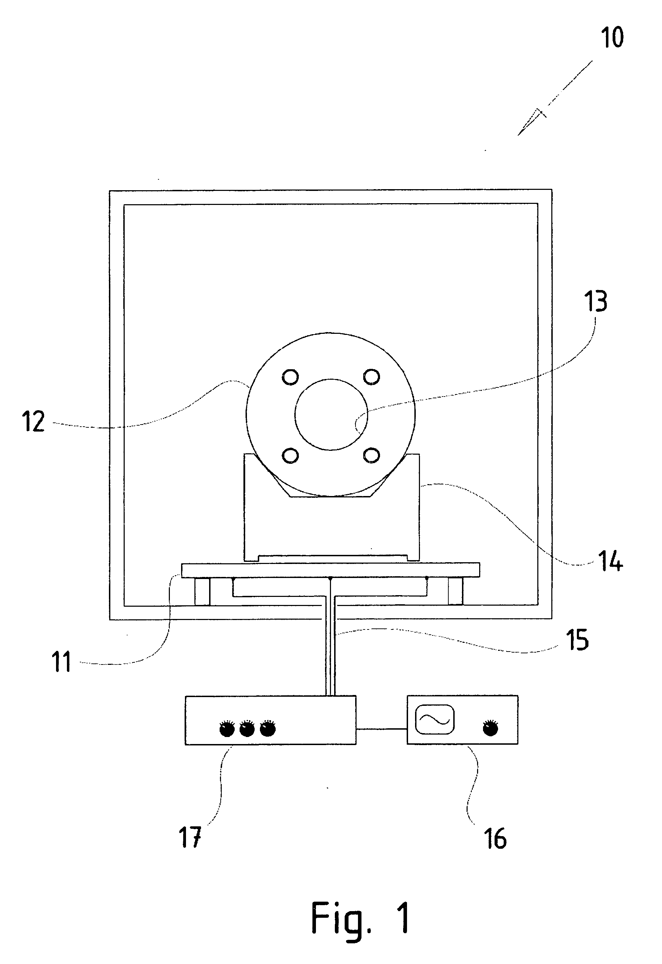

Fig.1 zeigt einen Schnitt durch eine erfindungsgemäße Vakuum-Kammer 10 in Frontalansicht mit einer am Boden der Kammer angeordneten Hochfrequenz-Elektrode 11, einem auf der Innenseite des zu beschichtenden Hohlkörpers 12 mit einer Öffnung 13, wobei letzteres über eine Halterung 14 auf der Hochfrequenz-Elektrode angeordnet ist.

Die Hochfrequenz-Elektrode 11 im Inneren der Vakuumkammer 10 weist drei Zuleitungen 15 auf, über die Hochfrequenz-Spannungen in die Hochfrequenz-Elektrode 11 eingespeist werden, die von einem Hochfrequenzgenerator (HF-Generator) 16 erzeugt werden. Über eine zwischen den HF-Generator 16 und die Hochfrequenz-Elektrode 11 geschaltete regelbaren sogenannte Matchbox 17 können mit Hilfe von Trimmpotentiometern die einzelnen Zuleitungen zu der Hochfrequenz-Elektrode 11 separat eingeregelt werden, um in der gesamten Kammer ein homogenes Wechselfeld mit gleichmäßig hohen Feldstärken zu erzeugen.

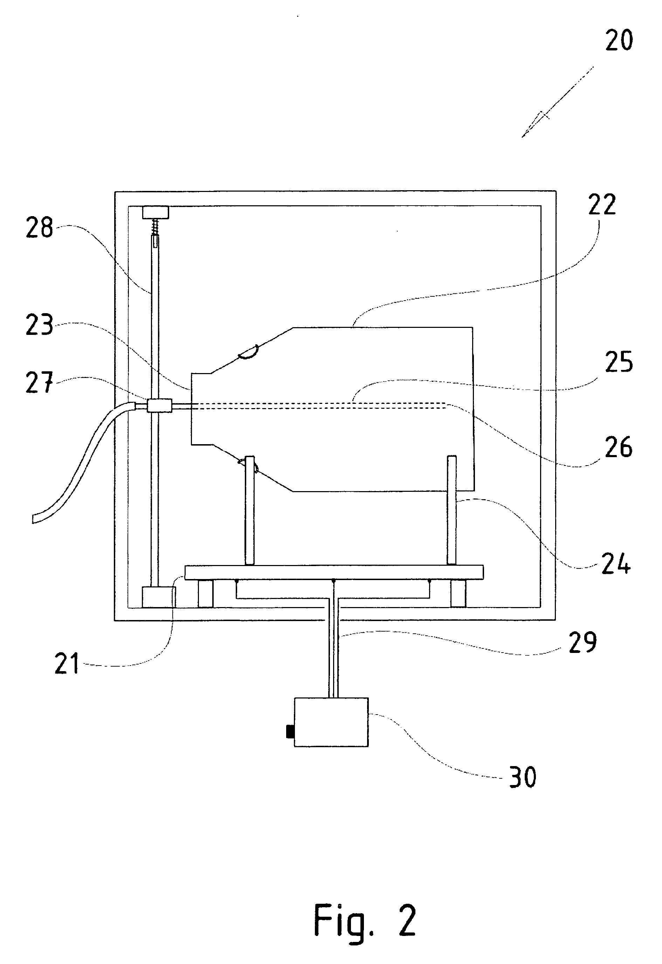

Fig. 2 zeigt dieselbe Vakuum-Kammer 20 in einer seitlichen Schnittansicht, mit der Hochfrequenz-Elektrode 21, dem auf der Innenseite zu beschichtenden Hohlkörper 22 in Draufsicht mit einer Öffnung 23 sowie der nicht elektrisch leitenden Halterung 24. Bei dem Hohlkörper handelt es sich im gezeigten Beispiel um eine Bulkkanne. Durch die Öffnung 23 des Hohlkörpers ist eine Gaslanze 25 in den Hohlkörper eingeführt, wobei letztere an ihrem distalen Ende eine endständige Düse 26 mit einem Durchmesser von 0,6 mm aufweist. Die Gaslanze steht über einen Schlauch mit einer nicht dargestellten Gasversorgung in Verbindung und ist über eine höhenverstellbare Halterung 27 geführt, mittels welcher sichergestellt werden kann, dass die Gaslanze gemäß der Dimensionierungen im Hauptanspruch in dem Hohlkörper 22 positioniert werden kann. Hierfür ist die Halterung höhenverstellbar an einem Träger 28 angeordnet.

Die Hochfrequenz-Elektrode 21 im Inneren der Vakuumkammer 20 weist drei Zuleitungen 29 auf, über die Hochfrequenz-Spannungen in die Hochfrequenz-Elektrode 21 eingespeist werden, die von einem Hochfrequenzgenerator (HF-Generator) 30 erzeugt werden. Über eine zwischen den HF-Generator 16 und die Hochfrequenz-Elektrode 11 geschaltete, nicht dargestellten regelbaren Matchbox können die einzelnen Zuleitungen zu der Hochfrequenz-Elektrode 21 separat eingeregelt werden.

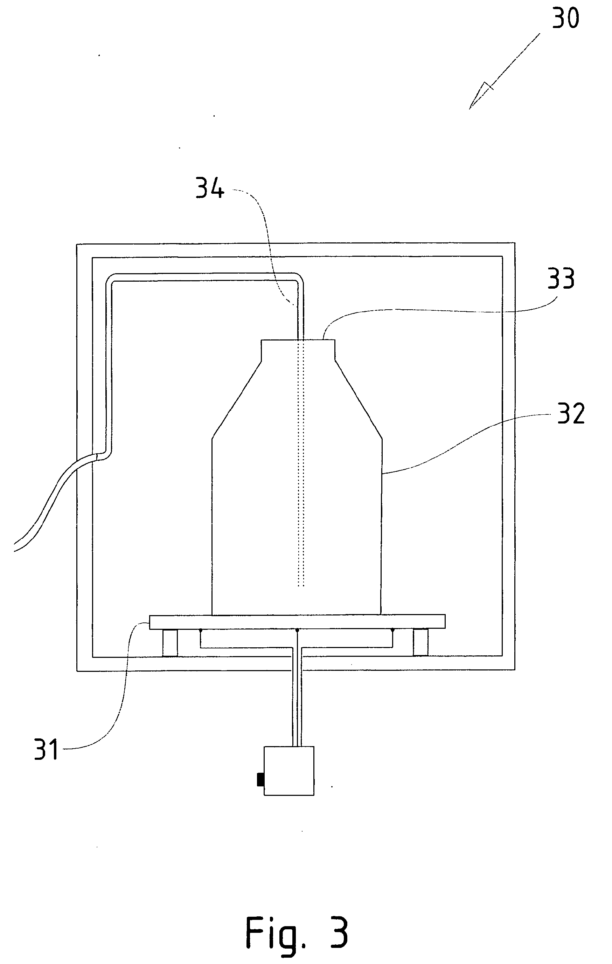

Fig. 3 zeigt erneut eine Vakuum-Kammer 30 in einer seitlichen Schnittansicht, mit einer Hochfrequenz-Elektrode 31, einem stehend angeordneten, auf der Innenseite zu beschichtenden Hohlkörper 32 in Draufsicht mit einer Öffnung 33, durch die eine Gaslanze 34 in den Hohlkörper eingeführt ist. Bei dem Hohlkörper handelt es sich im gezeigten Beispiel um eine Bulkkanne aus Edelstahl. Der Hohlkörper steht damit im Unterschied zu der in Fig. 2 gezeigten Ausführungsform in elektrisch leitender Verbindung mit der Hochfrequenz-Elektrode 31, fungiert daher ebenfalls als Elektrode.

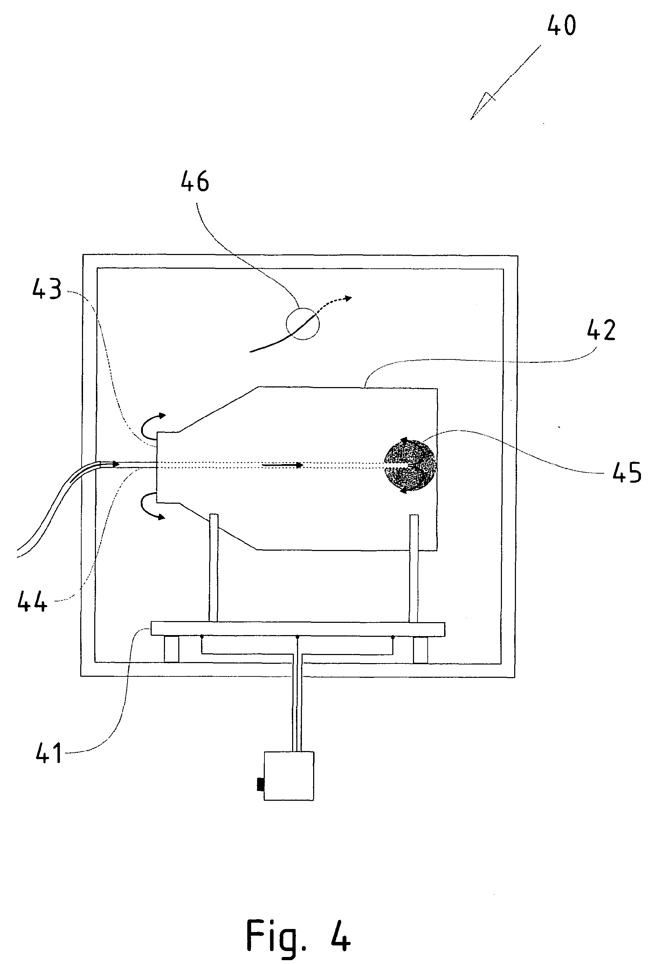

Fig. 4 zeigt dieselbe Vakuum-Kammer 40 wie Fig. 2, mit der Hochfrequenz-Elektrode 41, dem auf der Innenseite zu beschichtenden Hohlkörper 42 in Draufsicht mit einer Öffnung 43, durch die eine Gaslanze 25 in den Hohlkörper eingeführt ist. An der Hochfrequenzelektrode ist ein elektromagnetisches Wechselfeld eingestellt [Werte, drei Zuleitungen, sehr homogenes Feld] und durch die Gaslanze strömt Gas in den Hohlkörper ein. Aufgrund der elektromagnetischen Wechselwirkungen werden die austretenden Gasmoleküle beschleunigt und es bildet sich ein sphärisches Plasma 45 aus, das auch als Hohlraumplasma bezeichnet wird, da es im wesentlichen innerhalb des Hohlkörpers verbleibt und nicht in die eigentliche Vakuumkammer 40 übergeht. Aufgrund des Plasmas stellen sich dabei die oben beschriebenen Beschichtungseffekte ein. Aufgrund des über den Absaugstutzen 46 wird das ausströmende Gas bzw. Plasma in Richtung der Öffnung 43 gesogen.

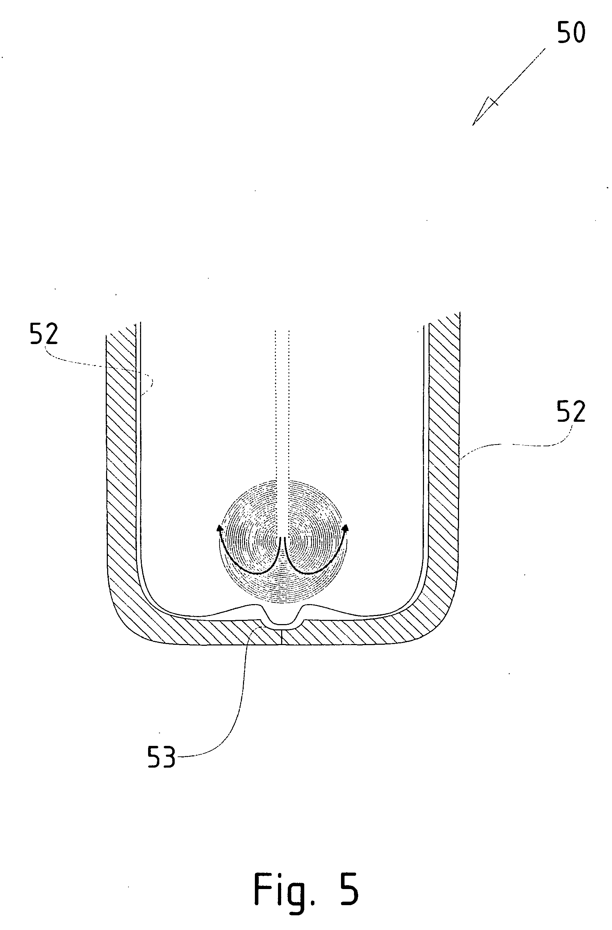

Fig. 5 zeigt eine beschichtete Bulkkanne 50 im Querschnitt mit einer Wand 51 und der Beschichtung 52.

Die Bulkkanne weist im Bereich ihres Bodens eine Vertiefung 53 auf. Schematisch dargestellt ist überdies die in den vorherigen Abbildungen gezeigte Gaslanze sowie das sich ausbildende sphärische Plasma. Es ist erkennbar, dass die aufgrund der Auswirkungen des sphärischen Plasmas aufgetragene Beschichtung insbesondere im Bereich der Austrittsöffnung der Gaslanze eine größere Stärke aufweist als in den Randbereichen des Kannenbodens bzw. an den Innenwänden der Kanne. Die Stärke der Beschichtung ist stark überhöht dargestellt, sie bewegt sich in der Praxis im Bereich zwischen 50 nm und 20 μm.

Bei unmittelbarer Betrachtung des Kannenbodens durch einen Beobachter ist dieser Dickegradient durch die changierende Farbe erkennbar, die durch Interferenzen mit den Wellen des sichtbaren Lichtspektrums (350 - 800 nm) hervorgerufen wird.

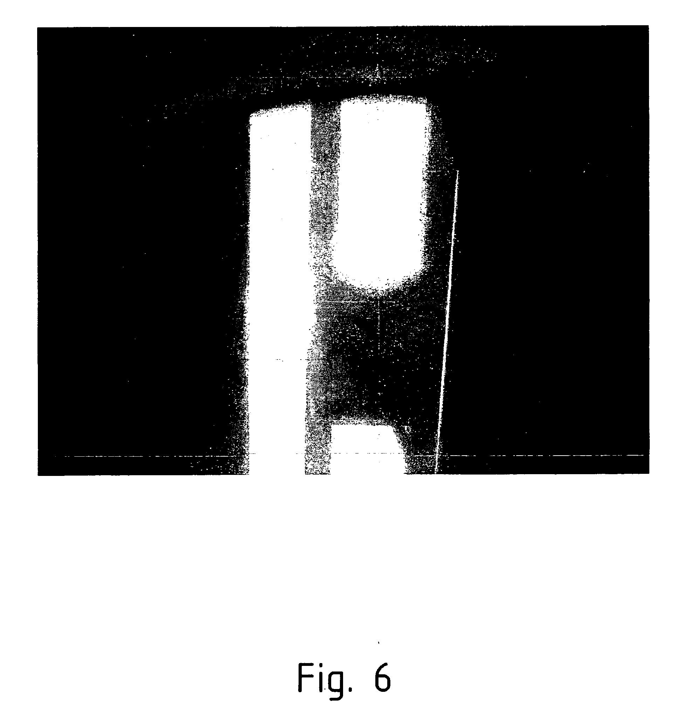

Fig. 6 zeigt den laufenden Beschichtungsprozess an einer horizontal angeordneten Bulkkanne. Hierzu wurde durch das Bullauge der Kammer in Richtung der Öffnung der Bulkkanne hineinfotografiert. Erkennbar ist, dass das sich ausgebildete Plasma lediglich im Inneren der Kanne brennt, und nicht etwa in der gesamten Kammer, wie dies bei Vorrichtungen aus dem Stand der Technik bekannt ist. Es handelt sich hierbei um das oben diskutierte Hohlraumplasma.

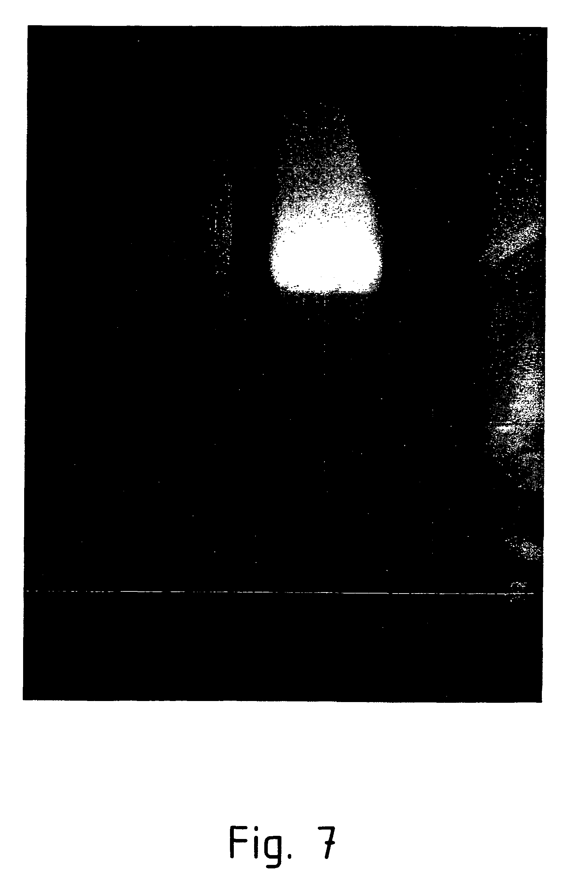

Fig. 7 zeigt den laufenden Beschichtungsprozess an einer vertikal angeordneten Bulkkanne. Hierzu wurde durch das Bullauge der Kammer in Richtung der Öffnung der Bulkkanne hineinfotografiert. Erkennbar ist auch hier, dass das sich ausgebildete Plasma lediglich im Inneren der Kanne brennt, und nicht etwa in der gesamten Kammer, wie dies bei Vorrichtungen aus dem Stand der Technik bekannt ist. Es handelt sich hierbei um das oben diskutierte Hohlraumplasma.

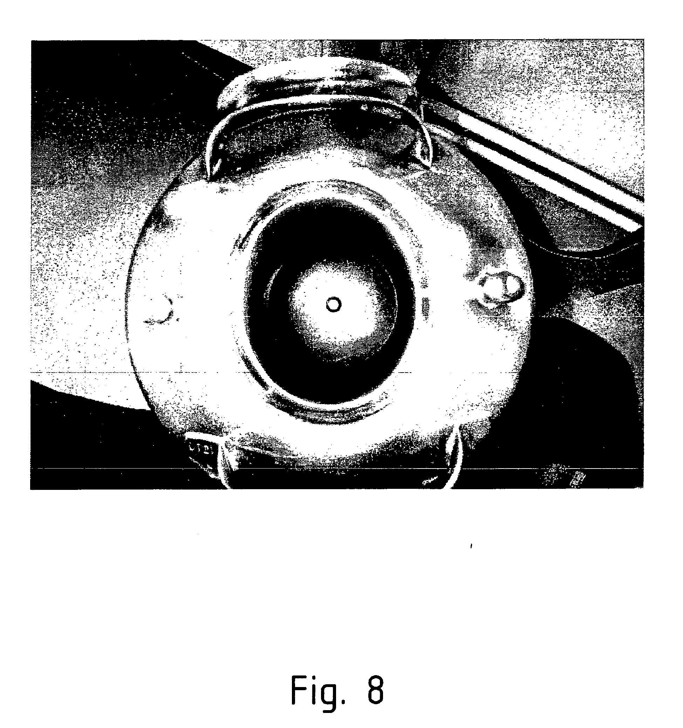

Fig. 8 zeigt eine mit dem erfindungsgemäßen Verfahren beschichtete Bulkkanne in Frontalansicht. Die Kanne ist noch in der Beschichtungskammer angeordnet, im unteren Bereich ist die nicht elektrisch leitende Halterung erkennbar. Insbesondere ist im Bereich des Bodens der Kanne die bereits diskutierte Vertiefung erkennbar. Es ist weiterhin gut erkennbar, dass die Kanne im Innenbereich mit einer DLC-Beschichtung beschichtet ist, während die Außenseite der Kanne nicht beschichtet ist (erkennbar an der metallisch glänzenden Oberfläche aus Edelstahl).

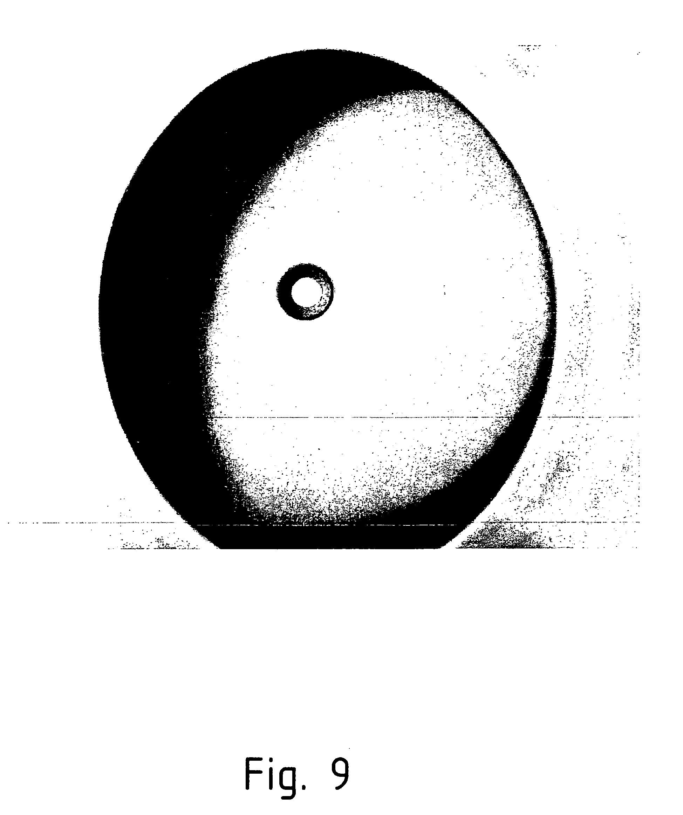

Fig. 9 zeigt den Boden einer mit dem erfindungsgemäßen Verfahren beschichteten Bulkkanne in Frontalansicht. Auch hier ist im Bereich des Bodens der Kanne die bereits diskutierte Vertiefung erkennbar. Auch hier ist anhand der unterschiedlichen Helligkeiten erneut gut erkennbar, dass die Kanne im Innenbereich mit einer DLC-Beschichtung beschichtet ist, während die Außenseite der Kanne nicht beschichtet ist (erkennbar an der metallisch glänzenden Oberfläche aus Edelstahl).

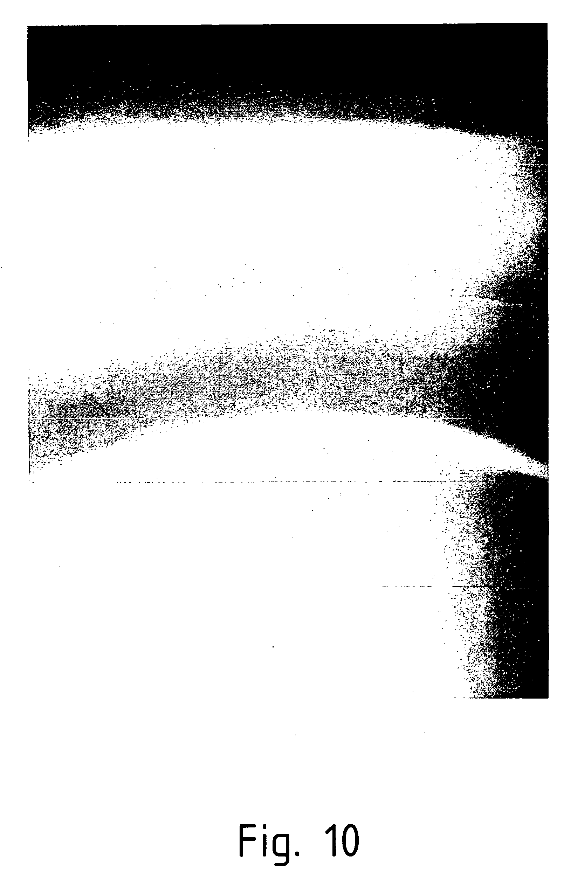

Fig. 10 zeigt den Übergangsbereich zwischen dem Boden und der Innenwand einer beschichteten Bulkkanne. Dabei ist insbesondere gut erkennbar, dass eine im Übergangsbereich angeordnete Schweißnaht ebenfalls gut beschichtet ist.

**Patentansprüche**

1. Verfahren zur plasmagestützten chemischen Gasphasenabscheidung zur Beschichtung bzw. Materialabtragung an der Innenwand eines Hohlkörpers (42), insbesondere aus einem nichtmetallischen Material, mit einer Querschnittsfläche, einer Längserstreckung und mindestens einer Öffnung (43), aufweisend die folgenden Schritte:

   - Einbringen des auf seiner Innenseite zu beschichtenden Hohlkörpers in eine Vakuumkammer (40) mit einer geerdeten Innenseite, wobei im Inneren der Vakuumkammer eine großflächige Hochfrequenz-Elektrode (41) angeordnet ist,
   - Positionieren des Hohlkörpers (42) in der Mitte der Vakuumkammer (40), wobei ein allseitiger Mindestabstand zwischen der Außenwand des Hohlkörpers und der Innenwand der Vakuumkammer von 15 cm einzuhalten ist,
   - Einbringen einer Gaslanze (44) bestehend aus einem Rohr mit einem Innendurchmesser von 0,001 - 10 mm, einem maximalen Außendurchmesser von 12 mm sowie einer endständigen Düse mit einem terminalen Öffnungsdurchmesser von 0,002 - 6 mm durch die Öffnung in den Hohlkörper, wobei die Gaslanze über eine nicht elektrisch leitende Gasleitung mit einer Gaszufuhreinrichtung verbunden ist und insbesondere nicht geerdet ist oder in elektrisch leitendem Kontakt mit der Hochfrequenzelektrode steht,
   - Positionieren der Gaslanze in dem Hohlkörper dergestalt, dass die Gaslanze bezogen auf den Querschnitt des Hohlkörpers mittig positioniert ist und die Düse der Gaslanze bezogen auf die Längserstreckung des Hohlkörpers im Bereich des Übergangs vom zweiten Längsdrittel zum dritten Längsdrittel, gemessen von der Öffnung des Hohlkörpers, angeordnet ist,
   - Verschließen der Vakuumkammer und Evakuieren derselben auf einen Restdruck von 0,001-20 Pascal,
   - Einleiten eines inerten Arbeitsgases sowie eines oder mehrerer Reaktionsgase über die Gaszufuhreinrichtung und die Gaslanze in den Hohlkörper, sowie
   - Zünden eines Hohlraumplasmas (45) unter Ausbildung einer an der Spitze der Gaslanze angeordneten Plasmawolke durch Anlegen eines elektrischen Hochfrequenzfeldes an der HF-Elektrode,

   wobei die Hochfrequenz-Elektrode im Inneren der Vakuumkammer mindestens zwei Zuleitungen, über die Hochfrequenz-Spannungen in die Hochfrequenz-Elektrode einspeisbar sind, aufweist.

2. Verfahren gemäß einem der vorherigen Ansprüche, **dadurch gekennzeichnet, dass** die einzelnen Zuleitungen zu der Hochfrequenz-Elektrode separat eingeregelt werden, dergestalt, dass in der gesamten Kammer, ein homogenes Wechselfeld mit gleichmäßig hohen Feldstärken erzeugbar ist.

3. Verfahren gemäß einem der vorherigen Ansprüche, **dadurch gekennzeichnet, dass** der besagte Hohlkörper eine Öffnung aufweist, deren engster Durchmesser schmaler ist als der engste Durchmesser des Innenraums des Hohlkörpers

4. Verfahren gemäß einem der vorherigen Ansprüche, **dadurch gekennzeichnet, dass** der besagte Hohlkörper ein Innenvolumen von > 0,1 $ccm^3$ und < 1.000.000 $ccm^3$ aufweist.

5. Verfahren gemäß einem der vorherigen Ansprüche, **dadurch gekennzeichnet, dass** es sich bei dem Arbeitsgas um ein Gas ausgewählt aus der Gruppe enthaltend Argon, Helium, Wasserstoff, Sauerstoff oder ein anders Gas handelt.

6. Verfahren gemäß einem der vorherigen Ansprüche, **dadurch gekennzeichnet, dass**, dass es sich bei dem Reaktionsgas um ein Gas ausgewählt aus der Gruppe enthaltend Sauerstoff handelt.

7. Verfahren gemäß einem der Ansprüche 1-6, **dadurch gekennzeichnet, dass** es sich bei dem Reaktionsgas um ein Gas ausgewählt aus der Gruppe enthaltend Kohlenwasserstoffgase wie Methan, Ethan, Ethen, Ethin, Propan oder Silangase wie Tetramethylsilan oder Hexamethyldisiloxan handelt.

8. Verfahren gemäß einem der vorherigen Ansprüche, **dadurch gekennzeichnet, dass** das Plasma durch Anlegen eines Gleichspannungs-Hochfrequenzfeldes mit den folgenden Parametern gezündet wird:

   - Frequenz: 10 kHz 100 GHz
   - Elektrische Leistung 500 - 5000 W

9. Verfahren gemäß einem der vorherigen Ansprüche, **dadurch gekennzeichnet, dass** die einzubringende Menge des Reaktionsgases für die Beschichtung 0,1-10 $scm^3$. Reaktionsgas pro 10 $cm^2$ zu beschichtende innere Oberfläche beträgt.

10. Verfahren gemäß einem der vorherigen Ansprüche, **dadurch gekennzeichnet, dass** das Reaktionsgas mit einem oder mehreren Gasen enthaltend Si, N, F, B, O, Ag, Cu, V oder Ti dotiert ist.

**11.** Vorrichtung zur Durchführung eines Verfahrens gemäß einem der vorherigen Ansprüche, aufweisend

- eine Vakuum-Kammer (10) mit einer am Boden der Kammer angeordneten Hochfrequenzelektrode (11) sowie einer Halterung (14) für einen auf der Innenseite zu beschichtenden Hohlkörper,
- eine Gaslanze (25) bestehend aus einem Rohr mit einem Innendurchmesser von 0,001 - 10 mm, einem maximalen Außendurchmesser von 12 mm sowie einer endständigen Düse (26) mit einem terminalen Öffnungsdurchmesser von 0,002 - 4 mm, die über eine nicht elektrisch leitende Leitung mit einer Gaszufuhreinrichtung verbunden ist, und
- eine höhenverstellbare Halterung (2.7), mittels welcher sichergestellt werden kann, dass die Gaslanze (25) in dem Hohlkörper (22) dergestalt positioniert werden kann,
- dass die Gaslanze (25) bezogen auf den Querschnitt des Hohlkörpers mittig positioniert ist und die Düse (26) der Gaslanze bezogen auf die Längserstreckung des Hohlkörpers im Bereich des Übergangs vom zweiten Längsdrittel zum dritten Längsdrittel, gemessen von der Öffnung des Hohlkörpers, angeordnet ist,

**dadurch gekennzeichnet, dass** die Hochfrequenz-Elektrode im Inneren der Vakuumkammer mindestens drei Zuleitungen, über die Hochfrequenz-Spannungen in die Hochfrequenz-Elektrode einspeisbar sind, aufweist.

**12.** Vorrichtung gemäß Anspruch 12, **dadurch gekennzeichnet, dass** die einzelnen Zuleitungen zu der Hochfrequenz-Elektrode separat einregelbar sind, dergestalt, dass in der gesamten Kammer, ein homogenes Wechselfeld mit gleichmäßig hohen Feldstärken erzeugbar ist.

**Claims**

**1.** Method for plasma-assisted chemical vapour deposition for coating or material removal on the inner wall of a hollow body (42), in particular from a nonmetallic material, having a cross-sectional area, a longitudinal extent and at least one opening (43), comprising the following steps:

- introducing the hollow body to be coated on its inner side into a vacuum chamber (40) with an earthed inner side, wherein a large-area highfrequency electrode (41) is disposed in the interior of the vacuum chamber,
- positioning the hollow body (42) in the centre of the vacuum chamber (40), wherein it is necessary to maintain a minimum distance of 15 cm on all sides between the outer wall of the hollow body and the inner wall of the vacuum chamber,
- introducing a gas lance (44) comprising a tube having an internal diameter of 0.001-10 mm, a maximum external diameter of 12 mm and a terminal nozzle having a terminal opening diameter of 0.002-6 mm through the opening into the hollow body, wherein the gas lance is connected to a gas feed unit via a non-electrically conductive gas line and, in particular, is not earthed or in electrically conductive contact with the radiofrequency electrode,
- positioning the gas lance in the hollow body in such a way that the gas lance is positioned centrally relative to the cross section of the hollow body and the nozzle of the gas lance, relative to the longitudinal extent of the hollow body, is disposed in the region of the transition from the second longitudinal third to the third longitudinal third, measured from the opening of the hollow body,
- closing the vacuum chamber and evacuating it to a residual pressure of 0.001-20 pascals,
- introducing an inert working gas and also one or more reaction gases via the gas feed unit and the gas lance into the hollow body, and
- igniting a cavity plasma (45) with formation of a plasma cloud arranged at the tip of the gas lance, by applying an electric high-frequency field to the HF electrode,

wherein the high-frequency electrode in the interior of the vacuum chamber has at least two leads via which radio-frequency voltages can be fed into the radio-frequency electrode.

**2.** Method according to any of the preceding claims, **characterized in that** the individual leads to the high-frequency electrode are adjusted separately in such a way that a homogeneous alternating field having uniformly high field strengths can be generated in the entire chamber.

**3.** Method according to any of the preceding claims, **characterized in that** said hollow body has an opening whose narrowest diameter is narrower than the narrowest diameter of the inner space of the hollow body.

**4.** Method according to to any of the preceding claims, **characterized in that** said hollow body has an internal volume >0.1 ccm$^3$ and <1,000,000 ccm$^3$.

**5.** Method according to any of the preceding claims, **characterized in that** the working gas is a gas selected from the group containing argon, helium, hydrogen, oxygen or a different gas.

**6.** Method according to any of the preceding claims, **characterized in that** the reaction gas is a gas selected from the group containing oxygen.

**7.** Method according to claims 1 - 6 , **characterized in that** the reaction gas is a gas selected from the group containing hydrocarbon gases such as methane, ethane, ethene, ethyne, propane or silane gases such as tetramethylsilane or hexamethyldisiloxane.

**8.** Method according to any of the preceding claims, **characterized in that** the plasma is ignited by applying a direct current high -frequency field with the following parameters:

- frequency: 10 kHz-100 GHz
- electrical power: 500-5000 W.

**9.** Method according to any of the preceding claims, **characterized in that** the amount of reaction gas to be introduced for the coating is 0.1-10 scm$^3$ of reaction gas per 10 cm$^2$ of inner surface to be coated.

**10.** Method according to any of the preceding claims, **characterized in that** the reaction gas is doped with one or more gases containing Si, N, F, B, O, Ag, Cu, V or Ti.

**11.** Device for carrying out a method according to any of the preceding claims, comprising

- a vacuum chamber (10) with a high-frequency electrode (11) disposed at the bottom of the chamber, and with a mount (14) for a hollow body to be coated on the inner side,
- a gas lance (25) comprising a tube having an internal diameter of 0.001-10 mm, a maximum external diameter of 12 mm, and a terminal nozzle (26) having a terminal opening diameter of 0.002-4 mm, which is connected to a gas feed unit via a non-electrically conductive line, and
- a height-adjustable mount (27) that can be used to ensure that the gas lance (25) can be positioned in the hollow body (22) in such a way
- that the gas lance (25) is positioned centrally relative to the cross section of the hollow body and the nozzle (26) of the gas lance, relative to the longitudinal extent of the hollow body, is arranged in the region of the transition from the second longitudinal third to the third longitudinal third, measured from the opening of the hollow body,

**characterized in that** the high-frequency electrode in the interior of the vacuum chamber has at least three leads via which high-frequency voltages can be fed into the radio-frequency electrode.

**12.** Device according to claim 12, **characterized in that** the individual leads to the high-frequency electrode can be adjusted separately in such a way that a homogeneous alternating field having uniformly high field strengths can be generated in the entire chamber.

**Revendications**

**1.** Procédé de dépôt chimique en phase gazeuse assisté par plasma pour le revêtement ou l'enlèvement de matière sur la paroi intérieure d'un corps creux (42), fabriqué en particulier à partir d'un matériau non métallique, possédant une surface de section transversale, une extension longitudinale et au moins une ouverture (43), comprenant les étapes suivantes consistant :

- à introduire le corps creux devant être revêtu sur son côté intérieur dans une chambre à vide (40) pourvue d'un côté intérieur relié à la terre, une électrode haute fréquence de grande taille (41) étant disposée à l'intérieur de la chambre à vide,
- à positionner le corps creux (42) au milieu de la chambre à vide (40), une distance minimale générale de 15 cm devant être respectée entre la paroi extérieure du corps creux et la paroi intérieure de la chambre à vide,
- à introduire une lance à gaz (44) constituée d'un tube ayant un diamètre intérieur de 0,001 à 10 mm, un diamètre extérieur maximal de 12 mm ainsi que d'une tuyère terminale ayant un diamètre terminal d'ouverture de 0,002 à 6 mm à travers l'ouverture dans le corps creux, la lance à gaz étant reliée par une conduite de gaz non électriquement conductrice à un équipement d'approvisionnement en gaz et en particulier n'étant pas reliée à la terre ou étant en contact électriquement conducteur avec l'électrode haute fréquence,
- à positionner la lance à gaz dans le corps creux de telle sorte que la lance à gaz soit positionnée au milieu par rapport à la section transversale du corps creux et que la tuyère de la lance à gaz soit disposée, par rapport à l'extension longitudinale du corps creux, dans la zone de transition entre le deuxième tiers de longueur et le troisième tiers de longueur, mesurée à partir de l'ouverture du corps creux,
- à fermer la chambre à vide et à évacuer celle-ci à une pression résiduelle de 0,001 à 20 Pascal,
- à introduire un gaz de travail inerte ainsi qu'un ou plusieurs gaz de réaction par l'équipement d'approvisionnement en gaz et la lance à gaz dans le corps creux,

- ainsi qu'à enflammer un plasma de cavité (45) sous la formation d'un nuage de plasma disposé à la pointe de la lance à gaz par application d'un champ électrique haute fréquence au niveau de l'électrode HF,

l'électrode haute fréquence à l'intérieur de la chambre à vide comprenant au moins deux conduites, par l'intermédiaire desquelles des tensions haute fréquence peuvent être amenées dans l'électrode haute fréquence.

2. Procédé selon l'une des revendications précédentes, **caractérisé en ce que** les conduites individuelles vers l'électrode haute fréquence sont réglées séparément de telle sorte que, dans toute la chambre, un champ alternatif homogène avec des intensités de champ uniformément élevées puisse être produit.

3. Procédé selon l'une des revendications précédentes, **caractérisé en ce que** ledit corps creux comprend une ouverture dont le diamètre le plus étroit est plus étroit que le diamètre le plus étroit de l'intérieur du corps creux.

4. Procédé selon l'une des revendications précédentes, **caractérisé en ce que** ledit corps creux comprend un volume intérieur supérieur à 0,1 ccm$^3$ et inférieur à 1 000 000 ccm$^3$.

5. Procédé selon l'une des revendications précédentes, **caractérisé en ce qu'**il s'agit pour le gaz de travail d'un gaz choisi dans le groupe comprenant l'argon, l'hélium, l'hydrogène, l'oxygène, ou d'un autre gaz.

6. Procédé selon l'une des revendications précédentes, **caractérisé en ce qu'**il s'agit pour le gaz de réaction d'un gaz choisi dans le groupe comprenant l'oxygène.

7. Procédé selon l'une des revendications 1 à 6, **caractérisé en ce qu'**il s'agit pour le gaz de réaction d'un gaz choisi dans le groupe comprenant des gaz hydrocarbures tels que le méthane, l'éthane, l'éthène, l'éthyne, le propane ou des gaz de silane tels que le tétraméthylsilane ou l'hexaméthyldisiloxane.

8. Procédé selon l'une des revendications précédentes, **caractérisé en ce que** le plasma est enflammé par application d'une tension continue - d'un champ haute fréquence possédant les paramètres suivants :

   - fréquence : de 10 kHz à 100 GHz
   - puissance électrique de 500 à 5 000 W.

9. Procédé selon l'une des revendications précédentes, **caractérisé en ce que** la quantité du gaz de réaction à introduire s'élève pour le revêtement à une valeur de 0,1 à 10 scm$^3$ de gaz de réaction pour 10 cm$^2$ de surface intérieure à revêtir.

10. Procédé selon l'une des revendications précédentes, **caractérisé en ce que** le gaz de réaction est doté d'un ou plusieurs gaz contenant Si, N, F, B, O, Ag, Cu, V ou Ti.

11. Dispositif pour la mise en oeuvre d'un procédé selon l'une des revendications précédentes, comprenant :

   - une chambre à vide (10) pourvue d'une électrode haute fréquence (11) disposée au fond de la chambre ainsi que d'un support (14) pour un corps creux devant être revêtu sur le côté intérieur,
   - une lance à gaz (25) constituée d'un tube ayant un diamètre intérieur de 0,001 à 10 mm, un diamètre extérieur maximal de 12 mm ainsi que d'une tuyère terminale (26) ayant un diamètre terminal d'ouverture de 0,002 à 4 mm, qui est reliée par une conduite non électriquement conductrice à un équipement d'approvisionnement en gaz, et
   - un support réglable en hauteur (27), au moyen duquel il peut être garanti que la lance à gaz (25) dans le corps creux (22) peut être positionnée de telle sorte
   - que la lance à gaz (25) soit positionnée au milieu par rapport à la section transversale du corps creux et que la tuyère (26) de la lance à gaz soit disposée, par rapport à l'extension longitudinale du corps creux, dans la zone de transition entre le deuxième tiers de longueur et le troisième tiers de longueur, mesurée à partir de l'ouverture du corps creux,

   **caractérisé en ce que** l'électrode haute fréquence à l'intérieur de la chambre à vide comprend au moins trois conduites, par l'intermédiaire desquelles des tensions haute fréquence peuvent être amenées dans l'électrode haute fréquence.

12. Dispositif selon la revendication 12, **caractérisé en ce que** les conduites individuelles vers l'électrode haute fréquence sont réglables séparément de telle sorte que, dans toute la chambre, un champ alternatif homogène avec des intensités de champ uniformément élevées puisse être produit.

**Fig. 1**

Fig. 2

Fig. 3

Fig. 4

50

52

52

53

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19726443
- US 6180191 B1
- EP 1548149 A
- DE 3821815